# EUROPÄISCHE PATENTSCHRIFT

(11) **EP 3 618 219 B1**
(45) Veröffentlichungstag und Bekanntmachung des Hinweises auf die Patenterteilung: **14.04.2021**
(21) Anmeldenummer: 18191389.8
(22) Anmeldetag: 29.08.2018
(51) Int. Cl.: H02J 7/00, H02J 9/06

(54) **VERFAHREN ZUR WIEDERHERSTELLUNG EINES TIEFENTLADENEN BATTERIEMODULS SOWIE ZUGEHÖRIGES, UNTERBRECHUNGSFREIES STROMVERSORGUNGSSYSTEM**
METHOD FOR RESTORING AN OVER-DISCHARGED BATTERY MODULE AND CORRESPONDING UNINTERRUPTABLE POWER SUPPLY SYSTEM
PROCÉDÉ DE RESTAURATION D'UN MODULE DE BATTERIE SUR-DÉCHARGÉ ET SYSTÈME D'ALIMENTATION ININTERRUPTIBLE CORRESPONDANT

(43) Veröffentlichungstag der Anmeldung: 04.03.2020
(73) Patentinhaber: Siemens Aktiengesellschaft, 80333 München (DE)
(72) Erfinder: Bauhofer, Michael, 2322 Zwölfaxing (AT); Portisch, Daniel, 2170 Kleinhadersdorf (AT)
(74) Vertreter: Maier, Daniel Oliver

(56) Entgegenhaltungen:
- GB-A- 2 542 424
- US-B1- 9 680 333

## Beschreibung

### Technisches Gebiet

Die vorliegende Erfindung betrifft allgemein unterbrechungsfreie Stromversorgungssysteme oder so genannte Uninterruptable Power Supply- bzw. UPS-Systeme. Im Speziellen bezieht sich die vorliegende Erfindung auf ein Verfahren zur Wiederherstellung eines tiefentladenen Batteriemoduls in einem unterbrechungsfreien Stromversorgungssystem sowie ein zugehöriges, unterbrechungsfreies Stromversorgungssystem zur Durchführung des erfindungsgemäßen Verfahrens. Dabei umfasst das unterbrechungsfreie Stromversorgungssystem mindestens eine Grundeinheit sowie zumindest ein Batteriemodul mit zumindest zwei Akkumulatoreinheiten, welche jeweils eine zugehörige, interne Tiefentlade-Überwachung ausweisen. Das zumindest eine Batteriemodul ist über Anschlussleitungen an die Grundeinheit angebunden und kann von dieser räumlich getrennt angebracht sein.

### Stand der Technik

Ein gattungsgemäßes Verfahren ist beispielsweise aus dem Dokument US 9 680 333 B1 bekannt. Eine elektrische Schaltung mit einem Verpolschutz ist aus dem Dokument GB 2 542 424 A bekannt. Bei vielen elektrischen Anlagen werden heutzutage häufig Stromversorgungen installiert, welche aus einem dreiphasigen Energieversorgungsnetz, insbesondere einem Drehstromnetz, gespeist werden, und eine Gleichstrom-Ausgangsspannung (z.B. 24 Volt Gleichspannung) zur Versorgung der elektrischen Anlage liefern. Um einen Betrieb der elektrischen Anlage bzw. der jeweiligen Last unabhängig von Störungen und/oder Ausfällen im Energieversorgungsnetz sicherzustellen, werden üblicherweise unterbrechungsfreie Stromversorgungssysteme (kurz: USV) oder so genannte Uninterruptable Power Supply- bzw. UPS-Systeme eingesetzt. Die unterbrechungsfreie Stromversorgung dient dazu, auch bei einer Störung oder einem Ausfall der normalen Energieversorgung eine hilfsweise Energieversorgung für die elektrische Anlage bzw. die angeschlossene Last bereitzustellen. Dazu besteht ein unterbrechungsfreies Stromversorgungssystem typischer Weise aus einer Grundeinheit und einem oder mehreren Batteriemodulen, welche über Anschlussleitungen mit der Grundeinheit verbunden sind. Da Batteriemodule Gleichspannung zur Verfügung stellen, weisen die Anschlussleitungen bzw. die zugehörigen Anschlussklemmen eines Batteriemoduls eine Polarität auf - d.h. es gibt eine positive Anschlussleitung bzw. Anschlussklemme und ein negative Anschlussleitung bzw. Anschlussklemme, wobei die negative Anschlussleitung beispielsweise mit einem Massepotential der Grundeinheit verbunden werden kann.

Die Grundeinheit ist einerseits eingangsseitig mit der Stromversorgung und ausgangsseitig mit einer zu versorgenden Last verbunden. Sie umfasst zumindest eine Ladeeinheit bzw. einen Laderegler, eine Steuereinheit sowie eine Umschalteinheit. Die Ladeeinheit bzw. der Laderegler wird zum Laden des angebundenen Batteriemoduls bzw. der angebundenen Batteriemodule beispielsweise während des Netzbetriebs sowie zur Umsetzung eines Ladevorgangs und gegebenenfalls eines Entladevorgangs (z.B. zum Anpassen der Batteriespannung an ein gewünschtes Lastspannungsniveau z.B. eines Hoch- oder Tiefsetzers) eingesetzt. Von der Steuereinheit erfolgt auf Basis von Strom- und Spannungsmesswerten eine Ansteuerung der Ladeeinheit bzw. des Ladereglers und der Umschalteinheit. Mit Hilfe der Umschalteinheit kann im Fall einer Störung des Energieversorgungsnetzes von einem so genannten Netzbetrieb (d.h. Versorgung der Last aus dem Energieversorgungsnetz) auf einen so genannten Pufferbetrieb umgeschaltet werden. Beim so genannten Pufferbetrieb wird die Energieversorgung der angeschlossenen Last - zumindest kurzzeitig - von dem zumindest einen Batteriemodul zur Verfügung gestellt.

Das zumindest eine Batteriemodul umfasst zur Energiespeicherung zumindest eine Akkumulatoreinheit oder so genanntes Acku-Pack. In einem Batteriemodul sind häufig zumindest zwei oder mehr Akkumulatoreinheiten oder Akku-Packs in Serie angeordnet. Eine Akkumulatoreinheit oder ein Akku-Pack ist ein zusammengeschaltetes Paket von mehreren Akkumulatorzellen, welche durch eine Umhüllung oder ein Gehäuse zusammengehalten und vor äußeren Einflüssen geschützt werden. Die Akkumulatoreinheit stellt einen wiederaufladbaren Speicher für elektrische Energie, typischerweise auf Basis eines elektrochemischen Systems, durch welches beim Aufladen elektrische Energie in chemische (Speicher-)Energie umgewandelt und beim Entladen wieder in elektrische Energie zurückgewandelt wird. Akkumulatorzellen werden üblicherweise nach den jeweils verwendeten Materialien bezeichnet. Bekannte Akkumulatorzellen-Typen sind z.B. Lithium-Eisenphosphat-Akkumulatoren (LiFePO4-Akkumulatoren), Lithium-Ionen-Akkumulatoren, Blei-Akkumulatoren, etc.

Bei einer industriellen Anwendung von unterbrechungsfreien Stromversorgungssystemen können die Grundeinheit und das zumindest eine Batteriemodul räumlich getrennt voneinander angeordnet sein. Die Grundeinheit mit Ladeeinheit, Steuereinheit und Umschalteinheit befindet sich beispielsweise in einem Gehäuse, welches z.B. in einem Schaltschrank auf einer Hutschiene montiert wird. Das zugehörige Batteriemodul bzw. die zugehörigen Batteriemodule können z.B. wegen des niedrigeren Temperaturniveaus am Boden des Schaltschranks oder einer anderen Stelle angebracht werden.

Ohne Störungen bei der Energieversorgung wird von der unterbrechungsfreien Stromversorgung elektrische Energie sowohl an die angeschlossene Last als auch an das zumindest eine zugehörige Batteriemodul und damit an die Akkumulatoreinheiten des Batteriemoduls weitergeleitet - d.h. das Batteriemodul bzw. die Akkumulatoreinheiten werden aufgeladen. Bei Auftreten einer Störung in der Energieversorgung wird das zumindest eine Batteriemodul des unterbrechungsfreien Stromversorgungssystem mit der Last verbunden und beginnt sich zur Last hin zu entladen, um die elektrische Energieversorgung aufrecht zu erhalten. Wenn das Energieversorgungsnetz wieder in seinen Normalzustand zurückkehrt, werden wiederrum die Last und das zumindest eine Batteriemodul mit elektrischer Energie versorgt.

Das zumindest eine Batteriemodul kann im Fall einer Störung in der Energieversorgung allerdings nur eine begrenzte Zeit verwendet werden, da es andernfalls zu einer so genannten Tiefentladung von zumindest einer, gegebenenfalls auch mehreren Akkumulatoreinheiten des Batteriemoduls kommen kann. Für eine Tiefentladung einer Akkumulatoreinheit gibt es allerdings noch weitere Gründe wie z.B. Überalterung der jeweiligen Akkumulatoreinheit, eine defekte und nicht passende Ladeeinheit, passive Stromentnahme durch ein Gerät oder so genannte Selbstentladung, welche z.B. bei längerer Lagerung oder auf längeren Transportwegen auftreten kann. Die Selbstentladung bezeichnet von selbst ablaufende Vorgänge, welche dazu führen können, dass sich eine Akkumulatoreinheit auch ohne angeschlossene Last mehr oder weniger schnell entlädt. Dabei ist eine Selbstentladung einer Batterie umso kritischer, je geringer der jeweilige Ladezustand des Batteriemoduls ist. Bei einem geringen Ladezustand kann z.B. bereits einen relativ kurze Lager- oder Transportzeit zu einer Tiefentladung des Batteriemoduls führen.

Durch eine Tiefentladung - d.h. bei einer Stromentnahme bis zur nahezu vollständigen Erschöpfung der Kapazität der jeweiligen Akkumulatoreinheit -kann die jeweilige Akkumulatoreinheit irreversibel geschädigt bzw. ihre Lebensdauer und Speicherkapazität herabgesetzt werden. Gegebenfalls kann ein Wiederaufladen nicht mehr möglich sein. Bei manchen Akkumulatortypen wie z.B. bei Lithium-Ionen-Akkumulatoren kann es durch Tiefentladung zu instabilen Zuständen, starker Erwärmung und/oder beim Wiederaufladen zu Kurzschlüssen kommen. Daher sollte ein Entladevorgang bei Erreichen oder Unterschreiten einer so genannten Entladeschlussspannung beendet bzw. eine Akkumulatoreinheit vor einem Einsatz auf Tiefentladung geprüft werden. Die Entladeschlussspannung ist ein vorgegebener Kennwert der jeweiligen Akkumulatoreinheit, weleher vom jeweiligen Akkutyp abhängt. So weisen z.B. Lithium-Ionen-Akkumulatoren oder LiFePO4-Akkumulatoren eine Entladeschlussspannung von 2 bis 2,5 V auf.

Um eine Tiefentladung einer Akkumulatoreinheit bzw. deren Einsatz im tiefenentladenen Zustand zu verhindern, können Akkumulatoreinheiten z.B. eine interne Schutzelektronik mit einer so genannten Tiefentlade-Überwachung aufweisen. Durch eine derartigen Tiefentlade-Überwachung kann beispielsweise bei Erreichen bzw. Unterschreiten eines vorgegebenen Spannungswertes - üblicherweise der Entladeschlussspannung - ein Entladevorgang gestoppt und gegebenenfalls ein Ladestrom für ein Wiederaufladen dieser Akkumulatoreinheit begrenzt werden. Die Akkumulatoreinheit kann mittels der Tiefentlade-Überwachung beispielsweise in einen Schutzmodus geschaltet werden, in welchem eine Entladung unterbrochen sowie ein Wiederaufladen mittels unbegrenzten Ladestroms verhindern wird bzw. nur mit einem begrenzten Ladestrom gefahrlos ermöglicht wird. Aus der Schrift EP 2 113 982 B1 ist beispielsweise eine interne Schutzelektronik für eine Akkumulatoreinheit, insbesondere ein Akku-Pack für Lithium-Ion-Akkumulatorzellen, bekannt, welche neben einer Lade-Überwachung auch eine Tiefentlade-Überwachung auf Basis einer Spannungsüberwachung an der jeweiligen Akkumulatorzellen der Akkumulatoreinheit ermöglicht.

Bei Einsatz derartiger Akkumulatoreinheiten mit interner Tiefentlade-Überwachung in einem Batteriemodul in einer unterbrechungsfreien Stromversorgung kann es beispielsweise zu Problemen beim Laden bzw. Wiederaufladen des zumindest einen Batteriemoduls durch die Grundeinheit bzw. die Ladeeinheit der unterbrechungsfreien Stromversorgung kommen, wenn ein oder mehrere Akkumulatoreinheiten z.B. aufgrund langer Lagerung, eines langen Transportweges oder durch nicht zeitgerechte Aufladung nach einer normalen Entladung, etc. von der jeweiligen internen Tiefentlade-Überwachung in einen Schutzmodus geschaltet wurden. Es kann beispielsweise an den Anschlussklemmen des Batteriemoduls keine oder nur eine sehr geringe Klemmenspannung gemessen werden, anhand welcher z.B. ein Anschließen des Batteriemoduls mit richtigen Polaritäten nicht mehr festgestellt bzw. wodurch z.B. eine Verpolungsschutzeinrichtung in der Grundeinheit nicht mehr weggeschaltet werden kann. Das zumindest eine Batteriemodul bzw. die zugehörigen Akkumulatoreinheiten können dadurch über die Grundeinheit bzw. mittels der Ladeeinheit des unterbrechungsfreien Stromversorgungssystem beispielsweise nicht mehr aufgeladen und in einen Normalbetrieb gebracht werden und müssen daher ausgetauscht werden, wodurch zusätzliche Aufwände und Kosten entstehen.

### Darstellung der Erfindung

Der Erfindung liegt daher die Aufgabe zugrunde, ein Verfahren zur Wiederherstellung eines tiefentladenen Batteriemoduls in einem unterbrechungsfreien Stromversorgungssystem sowie ein zugehöriges Stromversorgungssystem anzugeben, durch welche auf einfache und kostengünstige Weise ein tiefentladenes Batteriemodul in einem unterbrechungsfreien Stromversorgungssystem wieder in einen aufladbaren Zustand, insbesondere Normalbetrieb, zurückgebracht werden kann.

Diese Aufgabe wird durch ein Verfahren der eingangs genannten Art sowie ein zugehöriges unterbrechungsfreies Stromversorgungssystem mit den Merkmalen gemäß den unabhängigen Patentansprüchen gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren zur Wiederherstellung eines tiefentladenen Batteriemoduls in einem unterbrechungsfreien Stromversorgungssystem der eingangs erwähnten Art, wobei nach Beginn bzw. Einschalten einer netzseitigen Energieversorgung eine Klemmenspannung des zumindest einen Batteriemoduls z.B. an der positiven Anschlussleitung bzw. Anschlussklemme des Batteriemoduls ermittelt wird. Diese Klemmenspannung wird mit einem vorgebbaren Schwellwert verglichen. Nach Ablauf einer vorgebbaren Wartezeit (z.B. 10 Minuten) und bei Unterschreiten des Schwellwerts wird eine Verpolungsschutzeinheit für eine vorgebbare, sehr kurze Zeitdauer bzw. einen vorgebbaren Zeitimpuls (z.B. 0,5 Sekunden) aktiviert, wobei die Verpolungsschutzeinheit in einer der Anschlussleitungen zwischen der Grundeinheit und dem zumindest einen Batteriemodul angeordnet ist. Wird zwischen der Grundeinheit und dem zumindest einen Batteriemodul des Stromversorgungssystems eine Kommunikation festgestellt, so wird die Verpolungsschutzeinheit dauerhaft eingeschaltet und im zumindest einen Batteriemoduls mittels eines Belastungsnetzwerkes an jeder der zumindest zwei Akkumulatoreinheiten ein jeweiliger Spannungsabfall ermittelt. Der jeweilige Spannungsabfall an der jeweiligen Akkumulatoreinheit wird dann mit einer vorgegebenen Mindestspannung verglichen. Bei Unterschreiten der vorgegebenen Mindestspannung durch zumindest einen der an den jeweiligen Akkumulatoreinheiten ermittelten Spannungsabfälle wird eine vorgegebene Ladespannung an das zumindest eine Batteriemodul solange angelegt, bis entweder eine vorgebbare Zeitdauer (z.B. 12 Stunden) überschritten wird oder von einem in der Grundeinheit ermittelten Ladestrom ein vorgebbarer Stromwert (z.B. 500 mA) überstiegen wird.

Der Hauptaspekt der erfindungsgemäß vorgeschlagenen Lösung besteht darin, dass einerseits festgestellt werden kann, ob ein Batteriemodul tatsächlich defekt ist oder nur eines oder mehrere Akkumulatoreinheiten durch die jeweilige, interne Tiefentlade-Überwachung in einen Schutzmodus z.B. aufgrund langer Lagerung, längerer Transportwege oder nicht zeitgerechter Aufladung nach einem betriebsmäßigen Gebrauch geschaltet wurden. Im Schutzmodus wird z.B. durch die interne Tiefentlade-Überwachung eine Entladung der jeweiligen Akkumulatoreinheit unterbunden und ein Ladestrom auf eine für den jeweiligen Akku-Typ unbedenklichen Wert begrenzt. Andererseits kann durch das erfindungsgemäße Verfahren ein Batteriemodul eines unterbrechungsfreien Stromversorgungssystems, bei welchem zumindest eine Akkumulatoreinheit durch die jeweilige, interne Tiefentlade-Überwachung ein Schutzmodus aktiviert wurde, auf einfache Weise wieder in einen aufladbaren Zustand bzw. normalen Ladebetrieb übergeführt und wiederaufgeladen werden. Bei einem normalen Ladebetrieb wird das Batteriemodul beispielsweise mit einer vorgegebenen Ladespannung und einem vorgegebenen maximalen Ladestrom geladen, welche durch den jeweiligen Akkumulatortypen definiert werden. Das Batteriemodul ist damit wieder im unterbrechungsfreien Stromversorgungssystem einsetzbar und muss z.B. nicht ausgetauscht werden.

Idealerweise werden für eine Ermittlung des jeweiligen Spannungsabfalls an der jeweiligen Akkumulatoreinheit durch das Belastungsnetzwerk Belastungseinheiten nach einer vorgebbaren Reihenfolge zugeschaltet. Dabei wird z.B. ausgehend von einer ersten Belastungseinheit beispielsweise nach der vorgebbaren Reihenfolge immer eine weitere Belastungseinheit zugeschaltet. Das Belastungsnetzwerk ist dazu beispielsweise parallel zu den zumindest zwei Akkumulatoreinheiten angeordnet, wobei die Belastungseinheiten z.B. in Serie angeordnet sind und jeweils zumindest einen Widerstand und ein zum Widerstand in Serie angeordnetes Schaltelement umfassen.

Weiterhin ist es von Vorteil, wenn vor jedem Ladevorgang des Batteriemoduls - z.B. bei Anlegen der netzseitigen Energieversorgung nach einem Pufferbetrieb oder nach Anschließen eines neuen Batteriemoduls an die Grundeinheit des unterbrechungsfreien Stromversorgungssystems die jeweiligen Spannungsabfälle an den zumindest zwei Akkumulatoreinheiten des Batteriemoduls mit Hilfe des Belastungsnetzwerkes ermittelt werden. Auf diese einfache Weise kann rasch festgestellt werden, ob zumindest eine Akkumulatoreinheit durch die interne Tiefentlade-Überwachung in einen Schutzmodus geschaltet wurde.

Eine zweckmäßige Weiterentwicklung des erfindungsgemäßen Verfahrens sieht vor, dass während der vorgebbaren Zeitdauer oder solange vom in der Grundeinheit ermittelten Ladestrom der vorgebbaren Stromwert nicht überschritten wurde, vom zumindest einen Batteriemodul ein so genannter Tiefentladezustand angezeigt wird. Das bedeutet, es ist damit sehr rasch ersichtlich, dass sich das Batteriemodul bzw. das unterbrechungsfreie Stromversorgungssystem in einem Zustand befindet, in welchem ein tiefentladenes Batteriemodul wiederhergestellt werden kann. Wird nach Ablauf der vorgebbaren Zeitdauer (z.B. 12 Stunden) vom in der Grundeinheit ermittelten Ladestrom der vorgebbaren Stromwert immer noch nicht überschritten, dann wird in vorteilhafter Weise vom Batteriemodul ein Zustand "Batterie defekt" angezeigt. Damit ist auf eindeutige Weise für einen Benutzer ersichtlich, dass das Batteriemodul defekt ist bzw. nicht mehr in einen normalen Ladebetrieb gebracht werden kann und ausgetauscht werden muss. Vorteilhafter Weise kann über eine Anzeigeeinheit (z.B. mittel optischer Signalisierung, Bildschirm eines Ausgabegeräts, etc.) angezeigt werden, welche der zumindest zwei Akkumulatoreinheiten des Batteriemoduls zu tauschen ist. Bei Nutzung eines Bildschirms eines Ausgabegeräts als Anzeigeeinheit kann dieses z.B. über eine Bussystem (z.B. Profinet, etc.) mit dem unterbrechungsfreien Stromversorgungssystem verbunden und z.B. bei einer zentralen Steuerung platziert sein.

Bei einer bevorzugten Weiterentwicklung des erfindungsgemäßen Verfahrens wird bei Übersteigen des vorgebbaren Stromwerts durch den in der Grundeinheit ermittelten Ladestrom in einen normalen Ladebetrieb umgeschaltet wird und der normale Ladebetrieb von dem zumindest einen Batteriemodul angezeigt. D.h. es wird das Batteriemodul beispielsweise mit einer vorgegebenen Ladespannung und einem vorgegebenen maximalen Ladestrom geladen, welche durch den jeweiligen Akkumulatortypen definiert werden. Vor einem Umschalten vom so genannten Tiefentladezustand in den normalen Ladebetrieb kann z.B. eine bestimmte Zeitdauer (z.B. 1 Minute) abgewartet werden, um z.B. mögliche Störungen oder Fehlmessungen beim Ermitteln des Ladestroms in der Grundeinheit auszuschließen.

Weiterhin erfolgt die Lösung der Aufgabe durch ein unterbrechungsfreies Stromversorgungssystem zur Durchführung des erfindungsgemäßen Verfahrens, wobei das unterbrechungsfreie Stromversorgungssystem zumindest eine Grundeinheit und zumindest ein Batteriemodul umfasst, welches zumindest zwei Akkumulatoreinheiten mit jeweils zugehöriger Tiefentlade-Überwachung aufweist. Das zumindest eine Batteriemodul ist über Anschlussleitungen, zumindest eine positive und eine negative Anschlussleitung, an die Grundeinheit angebunden.

Dabei weist die Grundeinheit weiterhin eine Verpolungsschutzeinheit auf, welche in einer der Anschlussleitungen angeordnet ist, und durch welche ein Anschließen mit vertauschten Polaritäten des zumindest einen Batteriemoduls an die Grundeinheit (d.h. ein Vertauschen von positiver und negativer Anschlussleitung bzw. Anschlussklemme) verhindert werden soll. Die Verpolungsschutzeinheit ist in vorteilhafter Weise als Schalteinheit, insbesondere als Relais, Bipolartransistor oder Feldeffekttransistor (z.B. Metalloxid-Halbleiter-Feldeffekttransistor - kurz MOS-FET) ausgeführt. Die Verpolungsschutzeinheit wird beispielsweise dauerhaft eingeschaltet bzw. geschlossen, wenn feststellbar ist - z.B. anhand der ermittelten Klemmenspannung des Batteriemoduls, dass dieses mit richtigen Polaritäten mit der Grundeinheit verbunden ist.

Weiterhin weist das zumindest eine Batteriemodul ein Belastungsnetzwerk zum Ermitteln von Spannungsabfällen an jeder der zumindest zwei Akkumulatoreinheiten auf. Zusätzlich ist für eine Kommunikation zwischen der Grundeinheit und dem zumindest einen Batteriemodul zumindest eine Kommunikationsverbindung zum Austausch von Steuersignalen vorgesehen. Dabei wird von der Kommunikationsverbindung jene der Anschlussleitungen als Signalbasis bzw. als Rückleitung für die Kommunikation genutzt, in welcher die Verpolungsschutzeinheit angeordnet ist.

Weiterhin kann die Grundeinheit des unterbrechungsfreien Stromversorgungssystems idealerweise zumindest eine Ladeeinheit zur Umsetzung von Lade- und Entladevorgängen und eine Steuereinheit zur Ansteuerung der der Ladeeinheit und zum Auswerten von Messwerten umfassen. Die Grundeinheit umfasst außerdem eine Umschalteinheit, mit welcher die Versorgung der Last zwischen einer netzversorgten Stromversorgung und einem Stromversorgung durch das Batteriemodul umgeschaltet werden kann. Im zumindest einen Batteriemodul kann weiterhin eine Kontrolleinheit für eine Kommunikation mit der Grundeinheit sowie zum Ansteuern des Belastungsnetzwerks und Auswerten der mittels des Belastungsnetzwerks ermittelten Spannungsabfälle vorgesehen sein.

Es ist weiterhin günstig, wenn das zumindest eine Batteriemodul eine Anzeigeeinheit aufweist, durch welche ein aktueller Zustand des zumindest einen Batteriemoduls anzeigbar ist. Mit Hilfe der Anzeigeeinheit kann auf einfache und kostengünstige Weise ein aktueller Zustand bzw. Status des Batteriemoduls - wie z.B. "Batteriemodul defekt", "Batteriemodul im Tiefentlade-Zustand" oder "Batteriemodul im Ladebetrieb", etc. angezeigt werden. Als Anzeigeeinheit können z.B. Leuchtdioden eingesetzt werden, welche durch Farb- und/oder Blicksignale den jeweiligen Zustand bzw. Status des Batteriemoduls anzeigen.

### Kurzbeschreibung der Zeichnung

Die Erfindung wird nachfolgend in beispielhafter Weise anhand der beigefügten Figuren erläutert. Dabei zeigen:
Figur 1 schematisch und beispielhaft ein unterbrechungsfreies Stromversorgungssysten gemäß einer Ausführungsform der Erfindung
Figur 2 schematisch einen beispielhaften Ablauf eines Verfahrens zur Wiederherstellung eines tiefenladenen Batteriemoduls in einem unterbrechungsfreien Stromversorgungssystem gemäß einer Ausführungsform der Erfindung
Figur 3 schematisch und beispielhaft das unterbrechungsfreie Stromversorgungssystem mit einer Grundeinheit und mehreren, parallel angebundenen Batteriemoduler gemäß einer Ausführungsform der Erfindung

### Ausführung der Erfindung

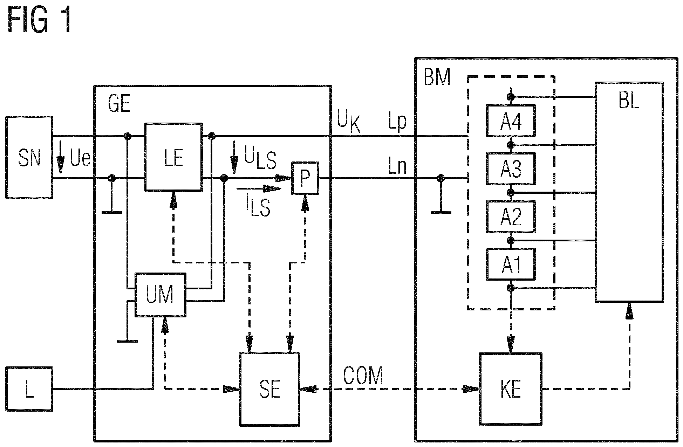

Figur 1 zeigt in schematischer und beispielhafter Weise ein unterbrechungsfreies Stromversorgungssystem gemäß einer Ausführungsform der Erfindung, durch welches bei einem Ausfall oder einer Störung eines versorgenden Stromnetzes, insbesondere Drehstromnetz, eine Versorgung einer Last L (z.B. elektrischen Anlage) aufrecht erhalten werden kann. Das unterbrechungsfreie Stromversorgungssystem ist über ein Schaltnetzteil SN mit dem Versorgungsnetz - üblicherweise einem Drehstromnetz - verbunden. Vom Schaltnetzteil SN wird eine mehrphasige Wechselspannung (meist eine 3-phasige Wechselspannung) in einen Gleichspannung Ue (z.B. 24 V) am Ausgang des Schaltnetzteils SN umgewandelt.

Das unterbrechungsfreie Stromversorgungssystem weist zumindest eine Grundeinheit GE sowie zumindest ein Batteriemodul BM auf. Dabei können die Grundeinheit GE und das Batteriemodul BM räumlich getrennt voneinander angebracht sein. Die Grundeinheit GE und das Batteriemodul BM sind über zumindest zwei Anschlussleitungen - eine positive Anschlussleitung Lp und eine negative Anschlussleitung Ln - verbunden, wobei die negative Anschlussleitung Ln mit einem Massepotential verbunden sein kann. Weiterhin ist es für eine Funktionsweise der Stromversorgung wichtig, dass die Anschlussleitungen Lp, Ln die Grundeinheit GE und die Batteriemodul BM mit den richtigen Polaritäten verbinden. D.h. die positive Anschlussleitung Lp sollte eine positive Anschlussklemme der Grundeinheit GE mit einer positiven Anschlussklemme des Batteriemoduls BM verbinden. Über die negative Anschlussleitung Ln sollte die negative Anschlussklemme der Grundeinheit GE, welche auch an ein Massepotential angebunden sein kann, mit der negativen Anschlussklemme des Batteriemoduls BM, welche ebenfalls an ein Massepotential angebunden sein kann, verbunden werden.

Um ein Vertauschen der Polaritäten zu verhindern, ist bei der Grundeinheit GE eine Verpolungsschutzeinheit P vorgesehen. Die Verpolungsschutzeinheit P ist in einer der zumindest zwei Anschlussleitungen Lp, Ln angeordnet - z.B. wie in Figur 1 dargestellt in der negativen Anschlussleitung Ln bzw. bei der negativen Anschlussklemme der Grundeinheit GE. Die Verpolungsschutzeinheit P kann als Schaltelement (z.B. Relais, Transistor, MOS-FET, etc.) ausgestaltet sein.

Die Grundeinheit GE umfasst weiterhin zumindest eine Steuereinheit SE und eine Ladeeinheit LE. Die Steuereinheit SE kann beispielsweise als Mikrocontroller ausgeführt sein und dient der Ansteuerung der Ladeeinheit LE sowie zum Auswerten von Messwerten (z.B. Spannungs- und/oder Stromwerten). Über die Ladeeinheit LE werden Lade- und/oder Entladevorgänge des zumindest einen Batteriemoduls BM geregelt - d.h. die Ladeeinheit LE sorgt dafür, dass ein Ladestrom I_{LS} und/oder eine Ladespannung U_{LS} bzw. ein Entladestrom und/oder eine Entladespannung innerhalb vorgegebener Grenzen bleibt. Die Grenzen für Strom und Spannung wie z.B. eine Höhe des Ladestroms (z.B. maximaler/minimaler Ladestrom), zulässige Entladeschlussspannung, etc. können beispielsweise zum Zeitpunkt des Hochlaufen des Stromversorgungssystems vom zumindest einen Batteriemodul BM an die Grundeinheit GE übertragen werden oder z.B. bei Installation oder Inbetriebnahme vom Betreiber fest eingestellt werden.

Weiterhin weist die Grundeinheit GE eine Umschalteinheit UM auf. Durch die Umschalteinheit UM wird bei einem Ausfall oder einer Störung des Versorgungsnetzes auf eine Versorgung der Last L mit der Gleichspannung durch das zumindest eine Batteriemodul BM umgeschaltet.

Das zumindest eine Batteriemodul BM weist zumindest zwei Akkumulatoreinheiten oder Akku-Packs A1, ..., A4, welche in Serie angeordnet sind. Jedes Akku-Pack A1, ..., A4 weist eine eigene, interne Tiefentlade-Überwachung auf, durch welche das jeweilige Akku-Pack A1, ..., A4 bei Unterschreiten von zumindest einem Spannungsschwellwert (z.B. der jeweiligen Entladeschlussspannung) in zumindest einen Schutzmodus geschaltet werden kann. Im Schutzmodus wird beispielsweise eine Entladung des Akku-Packs A1, ..., A4 gestoppt und durch die interne Tiefentlade-Überwachung ein Ladestrom auf einen relativ kleinen Stromwert (z.B. 150 mA) begrenzt. In einem Batteriemodul BM können z.B. drei oder wie in Figur 1 dargestellt vier Akkumulatoreinheiten A1, ..., A4 in Serie angeordnet sein. Als Akkumulatoreinheit A1, ..., A4 kann z.B. ein Lithium-Ionoder Lithium-Eisen-Phosphat-Akku-Pack verwendet werden.

Weiterhin umfasst das zumindest eine Batteriemodul BM ein Belastungsnetzwerk BL, welche beispielsweise parallel zu den Akkumulatoreinheiten A1, ..., A4 angeordnet ist. Das Belastungsnetzwerk BL besteht z.B. aus in Serie angeordneten Belastungseinheiten, welche nach einer definierten Reihenfolge zuschaltbar sind. Die jeweilige Belastungseinheit umfasst beispielsweise zumindest einen Widerstand und ein dazu in Serie angeordnetes Schaltelement, über welches die jeweilige Belastungseinheit bzw. der zumindest eine Widerstand zu- oder weggeschaltet werden kann.

Weiterhin weist das zumindest einen Batteriemodul BM eine Kontrolleinheit KE auf, welche beispielsweise als Mikrocontroller ausgeführt sein kann. Die Kontrolleinheit KE ist dazu eingerichtet, das Belastungsnetzwerk BL anzusteuern und mittels des Belastungsnetzwerks BL ermittelte Spannungsabfälle an den jeweiligen Akkumulatoreinheiten A1, ..., A4 auszuwerten. Weiterhin können in der Kontrolleinheit KE Parameter wie z.B. Ladeschlussspannung, maximaler Ladestrom, Entladeschlussspannung, Akkumulatortyp, Akkumulatorgröße, etc. für die Akkumulatoreinheiten A1, ..., A4 bzw. für das Batteriemodul BM hinterlegt sein. Die Kontrolleinheit KE ist auch für eine Kommunikation mit der Grundeinheit GE der unterbrechungsfreien Stromversorgung bzw. mit der Steuereinheit SE der Grundeinheit GE eingerichtet und kann z.B. beim Hochlaufen des Stromversorgungssystem die Parameter wie z.B. Ladeschlussspannung, maximaler Ladestrom, Entladeschlussspannung, Akkumulatortyp, Akkumulatorgröße, etc. der Akkumulatoreinheiten A1, ..., A4 bzw. des Batteriemoduls BM an die Steuereinheit SE der Grundeinheit GE übertragen.

Dazu ist eine Kommunikationsverbindung COM vorgesehen, über welche die Grundeinheit GE bzw. die zugehörige Steuereinheit SE und das zumindest eine Batteriemodul BM bzw. die zugehörige Kontrolleinheit KE Parameterdaten und/oder Steuersignale austauschen können. Von der Kommunikationsverbindung COM kann jene der Anschlussleitungen Lp, Ln als Signalbasis bzw. als Rückleitung für Daten- und/oder Signalaustausch genutzt, in welcher die Verpolungsschutzeinheit P angeordnet ist. D.h. von der Kommunikationsverbindung COM wird beispielsweise - wie in Figur 1 dargestellt - die negative Anschlussleitung Ln, in welcher die Verpolungsschutzeinheit P angeordnet ist, als Signalbasis verwendet. Weiterhin kann - in Figur 1 der Einfachheit halber nicht dargestellt - eine Leitung für eine Hilfsversorgung (z.B. 13 V) für die Kontrolleinheit KE des Batteriemoduls BM vorgesehen sein.

Das Batteriemodul BM kann außerdem eine Anzeigeeinheit aufweisen, durch welche ein aktueller Zustand des zumindest einen Batteriemoduls BM - wie z.B. Ladebetrieb, "Batterie defekt", etc. - angezeigt werden kann. Als Anzeigeeinheit können z.B. Leuchtdioden verwendet werden, durch welche mittels Farb- und/oder Blicksignalen der Zustand des Batteriemoduls angezeigt wird.

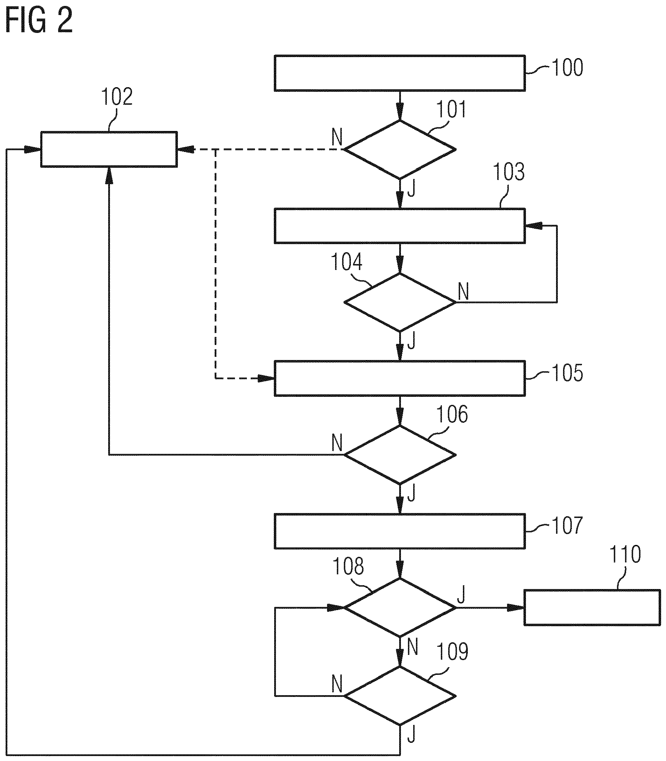

Figur 2 zeigt schematisch einen beispielhaften Ablauf eines Verfahrens zur Wiederherstellung eines tiefenladenen Batteriemoduls BM in einem unterbrechungsfreien Stromversorgungssystem gemäß einer Ausführungsform der Erfindung. In einer Startphase 100 wird z.B. nach Anschließen eines neuen Batteriemoduls BM an die Grundeinheit, nach längerem Pufferbetrieb, nach einer Ausschaltzeit der Stromversorgung, etc. eine netzseitige Versorgung Ue eingeschaltet. Es wird nach Beginn der netzseitigen Versorgung Ue eine Klemmenspannung U_{K} des zumindest einen Batteriemoduls BM beispielsweise an der positiven Anschlussleitung Lp bzw. an der positiven Anschlussklemmen des Batteriemoduls BM ermittelt.

In einer Vergleichsphase 101 für die Klemmenspannung U_{K} die Klemmenspannung U_{K} mit einem vorgebbaren Schwellwert verglichen werden. Übersteigt die ermittelte Klemmspannung U_{K} den vorgebbaren Schwellwert, so kann beispielweise in einen normalen Ladebetrieb 102 übergegangen werden bzw. es wird eine Kommunikationsphase 105 durchgeführt, in welcher die Verpolungsschutzeinheit P dauerhaft eingeschaltet und eine Kommunikation zwischen der Grundeinheit GE bzw. der zugehörigen Steuereinheit SE und dem zumindest einen Batteriemodul BM bzw. der zugehörigen Kontrolleinheit KE über die Kommunikationsverbindung COM aufgebaut wird.

Wird der vorgebbare Schwellwert von der ermittelten Klemmspannung U_{K} unterschritten, so wird nach Ablauf einer vorgebbaren Wartezeit (z.B. 10 Minuten) in einer Prüfphase 103 die Verpolungsschutzeinheit P, welche bei einer der Anschlussklemmen bzw. in einer der Anschlussleitungen Lp, Ln (z.B. bei der negativen Anschlussklemme bzw. in der negativen Anschlussleitung Ln) der Grundeinheit GE für das zumindest eine Batteriemodul BM angeordnet ist, kurzfristig bzw. für einen vorgebbaren Zeitimpuls (z.B. 0,5 Sekunden) eingeschaltet. In einer Kommunikationsprüfphase 104 wird überprüft, ob während der kurzfristigen Aktivierung der Verpolungsschutzeinheit P eine Kommunikation zwischen der Grundeinheit GE bzw. der zugehörigen Steuereinheit SE und dem zumindest einen Batteriemodul BM bzw. der zugehörigen Kontrolleinheit KE über die Kommunikationsverbindung COM zustande kommt.

Wird von der Grundeinheit GE kein Signal vom zumindest einen Batteriemodul über die Kommunikationsverbindung COM empfangen, dann wird - gegebenfalls nach Prüfung der Anschlussleitungen Lp, Ln bzw. ob das Batteriemodul BM mit richtigen Polaritäten an die Grundeinheit GE angebunden ist - nochmals die Prüfphase 103 und die Kommunikationsprüfphase 104 durchlaufen.

Meldet sich das zumindest eine Batteriemodul BM bzw. die zugehörige Kontrolleinheit KE bei der Grundeinheit GE, so ist dies ein Zeichen, dass das zumindest eine Batteriemodul BM korrekt an die Grundeinheit GE - d.h. nicht verpolt - angeschlossen ist. So wird das erfindungsgemäße Verfahren mit der Kommunikationsphase 105 fortgesetzt.

In der Kommunikationsphase 105 wird die Verpolungsschutzeinheit P dauerhaft eingeschaltet und die Kommunikation zwischen Grundeinheit GE und zumindest einem Batteriemodul BM über die Kommunikationsverbindung COM aufgebaut. Dabei werden vom Batteriemodul BM bzw. von der zugehörigen Kontrolleinheit KE Parameter der Akkumulatoreinheiten A1, ..., A4 bzw. des Batteriemoduls BM wie z.B. Akkumulatortyp, Akkumulatorgröße, Ladeschlussspannung, maximaler Ladestrom, Entladeschlussspannung, etc. an die Steuereinheit SE der Grundeinheit GE übertragen. Weiterhin wird in der Kommunikationsphase 105 die Kontrolleinheit KE des Batteriemoduls BM von der Steuereinheit SE der Grundeinheit GE angestoßen, eine Überprüfung der Akkumulatoreinheiten A1, ..., A4 mit Hilfe des Belastungsnetzwerks BL durchzuführen. Die Überprüfung der Akkumulatoreinheiten A1, ..., A4 kann beispielsweise vor jedem Ladevorgang des Batteriemoduls BM durchlaufen werden.

Dabei wird in einer Akkumulatorprüfphase 106 mittels des Belastungsnetzwerks an jeder der Akkumulatoreinheiten A1, ..., A4 ein jeweiliger Spannungsabfall ermittelt. Der für die jeweilige Akkumulatoreinheit A1, ..., A4 ermittelte Spannungsabfall wird dann in der Kontrolleinheit KE ausgewertet und dabei mit einer vorgegebenen Mindestspannung (z.B. einer Entladeschlussspannung für den Akku-Typ der jeweiligen Akkumulatoreinheit) verglichen.

Um für jede der in Serie angeordneten Akkumulatoreinheit A1, ..., A4 einen zugehörigen Spannungsabfall ermitteln zu können, ist das Belastungsnetzwerk parallel zu den Akkumulatoreinheiten A1, ..., A4 angeordnet und besteht aus in Serien angeordneten Belastungseinheiten, welche zumindest einen Widerstand und eine Schaltelement in Serie umfassen. Über die jeweiligen Schaltelemente in den Belastungseinheiten können diese in einer vorgebbaren Reihenfolge über Ansteuerung durch die Kontrolleinheit KE für das Ermitteln des jeweiligen Spannungsabfalls zugeschaltet werden. Dabei wird z.B. für die Ermittlung eines ersten Spannungsabfalls an einer ersten Akkumulatoreinheit A1 die erste Belastungseinheit, welche parallel zur ersten Akkumulatoreinheit A1 angeordnet ist, zugeschaltet. Der für die erste Akkumulatoreinheit A1 ermittelte, erste Spannungsabfall wird dann mit der vorgegebenen Mindestspannung verglichen. Zum Bestimmen eines zweiten Spannungsabfalls an einer zweiten Akkumulatoreinheit A2 wird beispielsweise zum ersten Belastungselement ein zweites Belastungselement, welche parallel zur zweiten Akkumulatoreinheit A2 angeordnet ist, zugeschaltet. Der für die zweite Akkumulatoreinheit A2 ermittelte, zweite Spannungsabfall wird dann ebenfalls mit der vorgegebenen Mindestspannung verglichen. Für die weiteren Akkumulatoreinheiten A3, A4 wird nach derselben Weise vorgegangen, bis für alle im Batteriemodul BM eingesetzten Akkumulatoreinheiten A1, ..., A4 ein zugehöriger Spannungsabfall ermittelt und z.B. durch die Kontrolleinheit KE mit der vorgegebenen Mindestspannung verglichen worden sind.

Wird in der Akkumulatorprüfphase 106 festgestellt, dass keine der Akkumulatoreinheiten A1, ..., A4 des zumindest einen Batteriemoduls BM die vorgegebenen Mindestspannung unterschreiten - d.h. beispielsweise, dass keine der Akkumulatoreinheiten A1, ..., A4 von der jeweils zugehörigen, internen Tiefentlade-Überwachung in einen Schutzmodus geschaltet wurde oder defekt ist, kann der normale Ladebetrieb 102 des Batteriemoduls - d.h. ein Laden des Batteriemoduls BM mit einem maximal möglichen Ladestrom I_{LS} - durchgeführt werden.

Wird in der Akkumulatorprüfphase 106 allerdings festgestellt, dass zumindest eine Akkumulatoreinheit A1, ..., A4 einen Spannungsabfall aufweist, von welchem die vorgegebene Mindestspannung unterschritten wird, so wird in einer Wiederherstellungsphase 107 für das zumindest eine Batteriemodul BM gestartet. D.h. die Ladeeinheit LE in der Grundeinheit wird dabei beispielsweise in einen Batteriewiederherstellungsmodus versetzt, wobei Schwellwerte für Ladeparameter (z.B. maximal zulässige Ladespannung, maximal möglicher Ladestrom, etc.) umgesetzt werden. Es wird dabei eine vorgegebene Ladespannung U_{LS} an das zumindest eine Batteriemodul BM angelegt. Weiterhin kann mittels Anzeigeeinheit des Batteriemoduls BM beispielsweise durch langsames Blinken einer roten Leuchtdiode der Tiefentlade-Zustand bzw. der Batteriewiederherstellungsmodus angezeigt werden.

Die vorgegebene Ladespannung wird dabei solange an das zumindest eine Batteriemodul BM angelegt und geprüft, welcher Ladestrom I_{LS} von dem zumindest einen Batteriemodul BM aufgenommen wird, bis entweder eine Zeitprüfung 108 eine Überschreitung einer vorgebbaren Zeitdauer wie z.B. 12 Stunden oder eine Ladestromprüfung 109 eine Übersteigen eines vorgebbaren Stromwerts durch einen in der Grundeinheit GE aktuell ermittelten Ladestrom I_{LS} ergibt. Das bedeutet, wird in der Zeitprüfung 108 festgestellt, dass die vorgebbare Zeitdauer erreicht oder überschritten wurde, ohne dass der aktuell in der Grundeinheit GE ermittelte Ladestrom ILS den vorgebbaren Stromwert (z.B. 500 mA) erreicht oder überstiegen hat, so wird das Verfahren mit einer Anzeigephase 110 beendet. In der Anzeigephase 110 wird beispielswiese über die Anzeigeeinheit des Batteriemoduls BM (z.B. rasches Blinken einer roten Leuchtdiode) angezeigt, dass das Batteriemodul defekt ist und z.B. getauscht werden muss. Alternativ oder zusätzlich, kann auch angezeigt werden, welche der Akkumulatoreinheiten A1, ..., A4 des Batteriemoduls zu tauschen ist.

Wird in der Stromprüfung 109 - vor Ablauf der vorgebbaren Zeitdauer - festgestellt, dass der aktuell in der Grundeinheit GE ermittelte Ladestrom I_{LS} den vorgebbaren Stromwert (z.B. 500 mA) überschritten hat, so kann z.B. nach einer vorgebbaren Zeit (z.B. 1 Minute) der Batteriewiederherstellungsmodus von der Ladeeinheit LE verlassen und auf einen normalen Ladebetrieb 102 mit dem maximal möglichen oder maximal zulässigen Ladestrom übergegangen werden. Dabei kann der normale Ladebetrieb über die Anzeigeeinheit des Batteriemoduls BM z.B. mittels Blinken oder Leuchten einer grünen Leuchtdiode angezeigt werden.

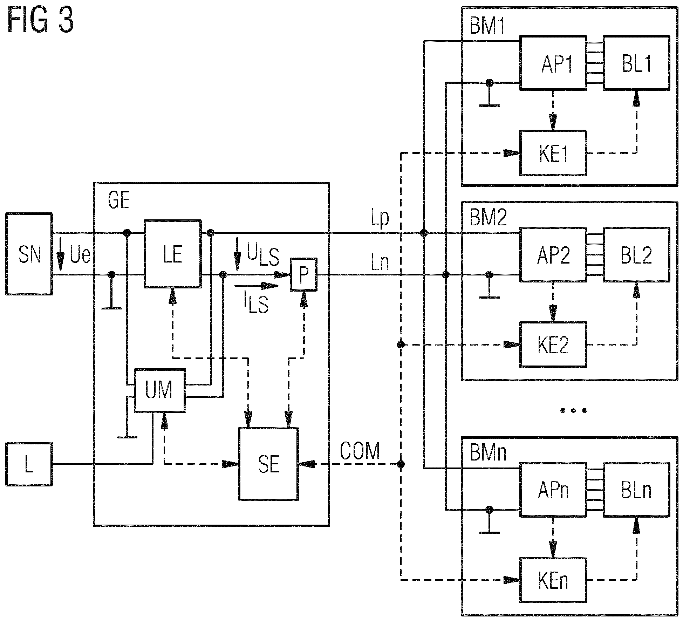

Figur 3 zeigt beispielhaft und schematisch das unterbrechungsfreie Stromversorgungssystem gemäß einer Ausführungsform der Erfindung, mit einer Grundeinheit GE, wobei über die positive und negative Anschlussleitung Lp, Ln mehrere (z.B. bis zu fünf) Batteriemodule BM1,..., BMn parallel an die Grundeinheit GE angebunden sind. Die Grundeinheit GE weist wieder eine Ladeeinheit LE, eine Umschalteinheit UM sowie eine Steuereinheit SE auf. In der negativen Anschlussleitung LN der Grundeinheit GE ist wieder einen Verpolungsschutzeinheit P vorgesehen, welche in einer der Anschlussleitungen Lp, Ln - z.B. der negativen Anschlussleitung Ln - angeordnet sein kann. Weiterhin können von der Grundeinheit GE bzw. der zugehörigen Steuereinheit SE mit den angebundenen Batteriemodulen B1, ..., Bn bzw. den jeweiligen Kontrolleinheiten KE1, ..., KEn über eine Kommunikationsverbindung COM Parameter- und/oder Signaldaten ausgetauscht werden.

Die angebundenen Batteriemodule BM1, ..., BMn weisen wiederum jeweils zumindest zwei in Serie angeordnete Akkumulatoreinheiten AP1, ..., APn mit jeweils zugehöriger, interner Tiefentlade-Überwachung auf. Der Einfachheit halber sind die Akkumulatoreinheiten der einzelnen Batteriemodule BM1, ..., BMn als Gesamteinheit AP1, ..., APn dargestellt. Weiterhin umfasst jedes Batteriemodul BM1, ..., BMn zumindest eine Kontrolleinheit KE1, ..., KEn sowie ein zu den Akkumulatoreinheiten AP1, ..., APn parallel angeordnetes Belastungsnetzwerk BL1, ..., BLn.

Bei einer parallelen Anschaltung vom mehreren Batteriemodulen BM1, ..., BMn wird das erfindungsgemäße Verfahren nur dann durchlaufen, wenn alle Batteriemodule BM1, ..., BMn zumindest ein Akku-Pack AP1, ..., APn aufweisen, welches über die jeweilige Tiefentlade-Überwachung in einen Schutzmodus geschaltet wurde. Bei zumindest einem Batteriemodul BM1, ..., BMn, welches eine normale Funktionsweise - d.h. kein Akku-Pack in einem Schutzmodus - aufweist, wird ein normaler Ladebetrieb 102 von der Grundeinheit GE durchgeführt. Erst wenn von dem zumindest einen Batteriemodul BM1, ..., BMn ohne Akku-Pack AP1, ..., APn in einem Schutzmodus die vorgegebene Ladeschlussspannung erreicht wurden (d.h. der normale Ladevorgang 102 diese zumindest einen Batteriemodul BM1, ..., BMn abgeschlossen ist), wird das zumindest eine Batteriemodul BM1, ..., BMn, bei welchem zumindest eine Akku-Pack AP1, ..., APn in einem Schutzmodus ist, mit Hilfe des erfindungsgemäßen Verfahrens geladen bzw. dadurch als defekt erkannt.

Weist bei einer parallelen Anbindung von mehreren Batteriemodulen BM1, ..., BMn an eine Grundeinheit GE zumindest eines der Batteriemodule BM1, ..., BMn zumindest ein Akku-Pack AP1, ..., APn in einem Schutzmodus auf und ist damit nicht verfügbar, so wird beispielsweise eine Anzeige einer Energiereserve entsprechend angepasst.

## Patentansprüche

1. Verfahren zur Wiederherstellung eines tiefentladenen Batteriemoduls (BM) in einem unterbrechungsfreien Stromversorgungssystem mit zumindest einer Grundeinheit (GE) und zumindest einem Batteriemodul (BM), welches zumindest zwei Akkumulatoreinheiten (A1, ..., A4) mit jeweils zugehöriger, interner Tiefentlade-Überwachung aufweist, wobei das zumindest eine Batteriemodul (BM) über Anschlussleitungen (Lp, Ln) an die Grundeinheit (GE) angebunden ist, ***dadurch gekennzeichnet, dass:***
nach Beginn einer netzseitigen Versorgung (Ue) eine Klemmenspannung (U_{K}) des zumindest einen Batteriemoduls (BM) ermittelt wird (100) und mit einem vorgebbaren Schwellwert verglichen wird (101);
dass bei Unterschreiten des Schwellwerts nach Ablauf einer vorgebbaren Wartezeit eine in einer der Anschlussleitungen (Lp, Ln) angeordnete Verpolungsschutzeinheit (P) für einen vorgebbaren Zeitimpuls eingeschaltet wird (103) ;
dass bei Feststellen einer Kommunikation zwischen der Grundeinheit (GE) und dem zumindest einen Batteriemodul (BM) während des Zeitimpulses die Verpolungsschutzeinheit (P) dauerhaft eingeschaltet wird und im zumindest einen Batteriemodul (BM) mittels eines Belastungsnetzwerkes (BL) an jeder der zumindest zwei Akkumulatoreinheiten (A1, ..., A4) ein jeweiliger Spannungsabfall ermittelt (104, 105) und der jeweilige Spannungsabfall mit einer vorgegebenen Mindestspannung verglichen wird (106);
und dass bei Unterschreiten der vorgegebenen Mindestspannung durch zumindest einen der an den jeweiligen Akkumulatoreinheiten (A1, ..., A4) ermittelten Spannungsabfälle eine vorgegebene Ladespannung (U_{LS}) an das zumindest eine Batteriemodul (BM) solange angelegt wird (107), bis entweder eine vorgebbare Zeitdauer überschritten wird (108) oder von einem in der Grundeinheit (GE) ermittelten Ladestrom (I_{LS}) ein vorgebbarer Stromwert überstiegen wird (109), je nachdem, welches dieser Ereignisse früher eintritt.

2. Verfahren nach Anspruch 1, ***dadurch gekennzeichnet, dass*** für eine Ermittlung des jeweiligen Spannungsabfalls an der jeweiligen Akkumulatoreinheit (A1, ..., A4) durch das Belastungsnetzwerk (BL) Belastungseinheiten nach einer vorgebbaren Reihenfolge zugeschaltet werden (105).

3. Verfahren nach einem der Ansprüche 1 bis 2, ***dadurch gekennzeichnet, dass*** vor jedem Ladevorgang des Batteriemoduls (BM) die jeweiligen Spannungsabfälle an den jeweiligen Akkumulatoreinheiten (A1, ..., A4) des Batteriemoduls mittels des Belastungsnetzwerkes ermittelt werden (105).

4. Verfahren nach einem der vorangegangenen Ansprüche, **da*durch gekennzeichnet, dass*** während der vorgebbaren Zeitdauer vom zumindest einen Batteriemodul (BM) ein Tiefentladezustand angezeigt wird (107, 108).

5. Verfahren nach einem der vorangegangenen Ansprüche, ***dadurch gekennzeichnet, dass*** nach Ablauf der vorgebbaren Zeitdauer von dem zumindest einen Batteriemodul (BM) ein Zustand "Batteriemodul defekt" angezeigt wird (110).

6. Verfahren nach einem der vorangegangenen Ansprüche, ***dadurch gekennzeichnet, dass*** bei Übersteigen des vorgebbaren Stromwerts durch den in der Grundeinheit (GE) ermittelten Ladestrom (I_{LS}) in einen normalen Ladebetrieb umgeschaltet wird und der normale Ladebetrieb von dem zumindest einen Batteriemodul (BM) angezeigt wird (109, 102).

7. Unterbrechungsfreies Stromversorgungssystem mit zumindest einer Grundeinheit (GE) und zumindest einem Batteriemodul (BM), welches zumindest zwei Akkumulatoreinheiten (A1, ..., A4) mit jeweils zugehöriger Tiefentlade-Überwachung aufweist, wobei das zumindest eine Batteriemodul (BM) über Anschlussleitungen (LP, Ln) an die Grundeinheit (GE) angebunden ist, ***dadurch gekennzeichnet, dass*** die Grundeinheit (GE) eine Verpolungsschutzeinheit (P) umfasst, welche in einer der Anschlussleitungen (Lp, Ln) angeordnet ist, dass weiterhin das zumindest eine Batteriemodul (BM) ein Belastungsnetzwerk (BL) zum Ermitteln von Spannungsabfällen an jeder der zumindest zwei Akkumulatoreinheiten (A1, ..., A4) aufweist, und dass für eine Kommunikation zwischen der Grundeinheit (GE) und dem zumindest einen Batteriemodul (BM) zumindest eine Kommunikationsverbindung (COM) zum Austausch von Steuersignalen vorgesehen ist, wobei die Kommunikationsverbindung (COM) jene Anschlussleitung (Ln) als Signalbasis nutzt, in welcher die Verpolungsschutzeinheit (P) angeordnet ist, wobei das unterbrechungsfreie Stromversorgungssystem zum Durchführen eines Verfahrens nach einem der Ansprüche 1 bis 6 eingerichtet ist.

8. Unterbrechungsfreies Stromversorgungssystem nach Anspruch 7, ***dadurch gekennzeichnet, dass*** die Grundeinheit (GM) zumindest eine Ladeeinheit (LE) zur Umsetzung von Lade- und Entladevorgängen und eine Steuereinheit (SE) zur Ansteuerung der Ladeeinheit (LE) und zum Auswerten von Messwerten umfasst, und dass das zumindest eine Batteriemodul (BM) eine Kontrolleinheit (KE) für eine Kommunikation mit der Grundeinheit (GE) sowie zum Ansteuern des Belastungsnetzwerks (BL) und Auswerten der mittels des Belastungsnetzwerks (BL) ermittelten Spannungsabfälle aufweist.

9. Unterbrechungsfreies Stromversorgungssystem nach einem der Ansprüche 7 bis 8, ***dadurch gekennzeichnet, dass*** das zumindest eine Batteriemodul (BM) eine Anzeigeeinheit aufweist, durch welche ein aktueller Zustand des zumindest einen Batteriemoduls (BM) anzeigbar ist.

10. Unterbrechungsfreies Stromversorgungssystem nach einem der Ansprüche 7 bis 9, ***dadurch gekennzeichnet, dass*** das Belastungsnetzwerk (BL) des zumindest einen Batteriemoduls (BM) aus in Serie angeordneten Belastungseinheiten besteht, welche jeweils zumindest einen mit einem Schaltelement in Serie angeordneten Widerstand umfassen und in einer vorgebbaren Reihenfolge zuschaltbar sind.

11. Unterbrechungsfreies Stromversorgungssystem nach einem der Ansprüche 7 bis 10, ***dadurch gekennzeichnet, dass*** die Verpolungsschutzeinheit (P) als Schalteinheit ausgestaltet ist.

## Claims

1. Method for reconditioning an exhausted battery module (BM) in an uninterruptible power supply system with at least one base unit (GE) and at least one battery module (BM), which has at least two accumulator units (A1, ..., A4) with associated internal exhaustive discharge monitoring in each case, wherein the at least one battery module (BM) is linked to the base unit (GE) via connection lines (Lp, Ln), ***characterised in that:***
after starting a network-side supply (Ue), a terminal voltage (U_{K}) of the at least one battery module (BM) is determined (100) and compared (101) with a predefinable threshold value;
if the threshold value is fallen below after a predefinable waiting time has elapsed, an inverse polarity protection unit (P) arranged in one of the connection lines (Lp, Ln) is switched on (103) for a predefinable time pulse;
if a communication between the base unit (GE) and the at least one battery module (BM) is ascertained during the time pulse, then the inverse polarity protection unit (P) is switched on permanently and, in the at least one battery module (BM), a respective voltage drop is determined (104, 105) by means of a load network (BL) at each of the at least two accumulator units (A1, ..., A4) and the respective voltage drop is compared (106) with a predefined minimum voltage;
and if at least one of the voltage drops determined at the respective accumulator units (A1, ..., A4) falls below the predefined minimum voltage, then a predefined charging voltage (U_{LS}) is applied (107) to the at least one battery module (BM) until either a predefinable period of time is exceeded (108) or a predefinable current value is surpassed (109) by a charging current (I_{LS}) determined in the base unit (GE), depending on which of these events occurs earlier.

2. Method according to claim 1, ***characterised in that,*** to determine the respective voltage drop at the respective accumulator unit (A1, ..., A4), load units are connected (105) by the load network (BL) according to a predefinable order.

3. Method according to one of claims 1 to 2, ***characterised in that,*** before each charging process of the battery module (BM) the respective voltage drops at the respective accumulator units (A1, ..., A4) of the battery module are determined (105) by means of the load network.

4. Method according to one of the preceding claims, ***characterised in that*** an exhaustive discharge state is indicated (107, 108) by the at least one battery module (BM) during the predefinable period of time.

5. Method according to one of the preceding claims, ***characterised in that*** a "defective battery module" state is indicated (110) by the at least one battery module (BM) once the predefinable period of time has elapsed.

6. Method according to one of the preceding claims, ***characterised in that,*** when the predefinable current value is surpassed by the charging current (I_{LS}) determined in the base unit (GE), a switch to a normal charging operation takes place and the normal charging operation is indicated (109, 102) by the at least one battery module (BM).

7. Uninterruptible power supply system with at least one base unit (GE) and at least one battery module (BM), which has at least two accumulator units (A1, ..., A4) with associated exhaustive discharge monitoring in each case, wherein the at least one battery module (BM) is linked to the base unit (GE) via connection lines (Lp, Ln), ***characterised in that*** the base unit (GE) comprises an inverse polarity protection unit (P), which is arranged in one of the connection lines (Lp, Ln), that furthermore the at least one battery module (BM) has a load network (BL) for determining voltage drops at each of the at least two accumulator units (A1, ..., A4), and that for communication between the base unit (GE) and the at least one battery module (BM) at least one communication connection (COM) is provided for exchanging control signals, wherein the communication connection (COM) uses the connection line (Ln), in which the inverse polarity protection unit (P) is arranged, as a signal basis, wherein the uninterruptible power supply system is configured to perform a method according to one of claims 1 to 6.

8. Uninterruptible power supply system according to claim 7, ***characterised in that*** the base unit (GM) comprises at least one charging unit (LE) for implementing charging and discharging processes and a control unit (SE) for actuating the charging unit (LE) and for evaluating measurement values, and that the at least one battery module (BM) has a controller unit (KE) for communicating with the base unit (GE) and also for actuating the load network (BL) and evaluating the voltage drops determined by means of the load network (BL).

9. Uninterruptible power supply system according to one of claims 7 to 8, ***characterised in that*** the at least one battery module (BM) has a display unit, by way of which a current state of the at least one battery module (BM) is able to be indicated.

10. Uninterruptible power supply system according to one of claims 7 to 9, ***characterised in that*** the load network (BL) of the at least one battery module (BM) consists of load units arranged in series, each comprising at least one resistor arranged in series with a switching element and being able to be connected in a predefinable order.

11. Uninterruptible power supply system according to one of claims 7 to 10, ***characterised in that*** the inverse polarity protection unit (P) is embodied as a switching unit.

## Revendications

1. Procédé de restauration d'un module de batterie (BM) déchargé profondément dans un système d'alimentation électrique sans coupure comprenant au moins une unité de base (GE) et au moins un module de batterie (BM), qui comprend au moins deux éléments d'accumulateur (A1, ..., A4) comprenant chacun un dispositif de surveillance de décharge profonde interne correspondant, dans lequel l'au moins un module de batterie (BM) est relié à l'unité de base (GE) par le biais de lignes de connexion (Lp, Ln),
**caractérisé en ce que** :
après le début d'une alimentation côté réseau (Ue), une tension aux bornes (U_{K}) du au moins un module de batterie (BM) est déterminée (100) et comparée (101) avec une valeur seuil prédéterminée,
**en ce qu'**en cas de sous-dépassement de la valeur seuil, après expiration d'un temps d'attente prédéterminé, un dispositif de protection contre les inversions de polarité (P) disposé dans une des lignes de connexion (Lp, Ln) est activé (103) pendant une impulsion de temps prédéterminée,
**en ce qu'**en cas d'identification d'une communication entre l'unité de base (GE) et l'au moins un module de batterie (BM) pendant l'impulsion de temps, le dispositif de protection contre les inversions de polarité (P) est activé en continu et une baisse de tension respective est déterminée (104, 105) dans au moins un module de batterie (BM) au moyen d'un réseau de charge (BL) sur chacun des au moins deux éléments d'accumulateur (A1, ..., A4) et la baisse de tension respective est comparée (106) avec une tension minimale prédéterminée, et
**en ce qu'**en cas de sous-dépassement de la tension minimale prédéterminée par au moins une des baisses de tension déterminées sur les éléments d'accumulateur respectifs (A1, ..., A4), une tension de charge (U_{LS}) prédéterminée est appliquée (107) sur l'au moins un module de batterie (BM) jusqu'à ce qu'une durée prédéterminable soit écoulée (108) ou qu'un courant de charge (I_{LS}) déterminé dans l'unité de base (GE) devienne supérieur (109) à une valeur de courant prédéterminable, selon lequel de ces événements surviendra le premier.

2. Procédé selon la revendication 1, **caractérisé en ce que**, pour une détermination de la baisse de tension respective sur l'élément d'accumulateur respectif (A1, ..., A4) par le réseau de charge (BL), des unités de charge sont commutées (105) selon un ordre prédéterminable.

3. Procédé selon l'une des revendications 1 à 2, **caractérisé en ce qu'**avant chaque processus de charge du module de batterie (BM), les baisses de tension respectives sur les éléments d'accumulateur (A1, ..., A4) du module de batterie sont déterminées (105) au moyen du réseau de charge.

4. Procédé selon l'une des revendications précédentes, **caractérisé en ce que**, pendant la durée prédéterminable, un état de décharge profonde est affiché (107, 108) par au moins un module de batterie (BM).

5. Procédé selon l'une des revendications précédentes, **caractérisé en ce qu'**après l'expiration de la durée prédéterminable, un état « module de batterie défectueux » est affiché (110) par l'au moins un module de batterie (BM).

6. Procédé selon l'une des revendications précédentes, **caractérisé en ce qu'**en cas de dépassement de la valeur de courant prédéterminable par le courant de charge (I_{LS}) déterminé dans l'unité de base (GE), le système est commuté en mode de charge normal et le mode de charge normal est affiché (109, 102) par l'au moins un module de batterie (BM) .

7. Système d'alimentation électrique sans coupure comprenant au moins une unité de base (GE) et au moins un module de batterie (BM), qui comprend au moins deux éléments d'accumulateur (A1, ..., A4) comprenant chacun un dispositif de surveillance de décharge profonde correspondant, dans lequel l'au moins un module de batterie (BM) est relié à l'unité de base (GE) par le biais de lignes de connexion (Lp, Ln),
**caractérisé en ce que** l'unité de base (GE) comprend un dispositif de protection contre les inversions de polarité (P) qui est disposé dans une des lignes de connexion (Lp, Ln) ,
**en ce qu'**en outre l'au moins un module de batterie (BM) comprend un réseau de charge (BL) pour identifier des baisses de tension sur chacun des au moins deux éléments d'accumulateur (A1, ..., A4), et
**en ce que**, pour une communication entre l'unité de base (GE) et l'au moins un module de batterie (BM), au moins une liaison de communication (COM) pour échanger des signaux de commande est prévue, dans lequel la liaison de communication (COM) utilise la ligne de connexion (Ln) dans laquelle le dispositif de protection contre les inversions de polarité (P) est disposé en tant que base de signal,
dans lequel le système d'alimentation électrique sans coupure est adapté pour exécuter un procédé selon l'une des revendications 1 à 6.

8. Système d'alimentation électrique sans coupure selon la revendication 7, **caractérisé en ce que** l'unité de base (GE) comprend au moins une unité de charge (LE) pour mettre en œuvre des processus de charge et de décharge et une unité de commande (SE) pour commander l'unité de charge (LE) et pour analyser des valeurs de mesure, et **en ce que** l'au moins un module de batterie (BM) comprend une unité de contrôle (KE) pour une communication avec l'unité de base (GE) ainsi que pour commander le réseau de charge (BL) et pour analyser les baisses de tension identifiées au moyen du réseau de charge (BL).

9. Système d'alimentation électrique sans coupure selon l'une des revendications 7 à 8, **caractérisé en ce que** l'au moins un module de batterie (BM) comprend une unité d'affichage, par laquelle un état instantané du au moins un module de batterie (BM) peut être affiché.

10. Système d'alimentation électrique sans coupure selon l'une des revendications 7 à 9, **caractérisé en ce que** le réseau de charge (BL) du au moins un module de batterie (BM) est constitué d'unités de charge montées en série, qui comprennent chacune au moins une résistance montée en série avec un élément de commutation et sont commutables dans un ordre prédéfini.

11. Système d'alimentation électrique sans coupure selon l'une des revendications 7 à 10, **caractérisé en ce que** le dispositif de protection contre les inversions de polarité (P) est configuré sous forme d'unité de commutation.
